# FASCICULE DE BREVET EUROPEEN

(11) **EP 2 230 206 B1**
(45) Date de publication et mention de la délivrance du brevet: **17.07.2013**
(21) Numéro de dépôt: 09155123.4
(22) Date de dépôt: 13.03.2009
(51) Int. Cl.: B81C 1/00, B81C 99/00, C25D 1/10, B29C 33/38

(54) **Moule pour galvanoplastie et son procédé de fabrication**
Form für Galvanoplastik und ihr Herstellungsverfahren
Electroplating mould and method for manufacturing same

(43) Date de publication de la demande: 22.09.2010
(73) Titulaire: Nivarox-FAR S.A., 2400 Le Locle (CH)
(72) Inventeur: Cusin, Pierre, 1423, Villars-Burquin (CH); Golfier, Clare, 2520, La Neuveville (CH); Thiébaud, Jean-Philippe, 1588, Cudrefin (CH)
(74) Mandataire: Couillard, Yann Luc Raymond

(56) Documents cités:
- EP-A- 0 547 371
- EP-A- 1 462 859
- EP-A- 1 681 375
- EP-A- 2 060 534
- DE-C1- 4 001 399

## Description

### Domaine de l'invention

L'invention se rapporte à un moule destiné à fabriquer une pièce de micromécanique par galvanoplastie ainsi que son procédé de fabrication.

### Arrière plan de l'invention

La galvanoplastie est utilisée et connue depuis longtemps. Les procédés du type LIGA (abréviation très connue provenant de l'allemand « röntgenLIthographie, Galvanoformung & Abformung ») sont plus récents. Ils consistent à former un moule par photolithographie d'une résine photosensible puis d'y faire croître par galvanoplastie un dépôt métallique comme du nickel. La précision de tels procédés LIGA est bien meilleure que celle d'un moule classique obtenue, par exemple, par usinage. De telles précisions autorisent ainsi la fabrication de pièces de micromécanique notamment pour des mouvements horlogers qui étaient avant inenvisageables.

Cependant, de tels procédés ne sont pas adaptés pour les pièces de micromécanique à grand élancement comme une roue d'échappement coaxiale en nickel - phosphore à, par exemple, 12% de phosphore. En effet, les dépôts électrolytiques de ce type de pièce délaminent en cours de dépôt en raison des contraintes internes du nickel - phosphore déposé ce qui a pour conséquence un décollement au niveau de son interface avec le substrat.

### Résumé de l'invention

Le but de la présente invention est de pallier tout ou partie les inconvénients cités précédemment en proposant un moule alternatif offrant au moins les mêmes précisions de fabrication et autorisant la fabrication de pièces à plusieurs niveaux et/ou à grand élancement.

A cet effet, l'invention se rapporte à un procédé de fabrication d'un moule comportant les étapes suivantes :
a) déposer une couche électriquement conductrice sur le dessus et sur le dessous d'une plaque en matériau à base de silicium ;
b) solidariser ladite plaque à un substrat à l'aide d'une couche adhésive ;
c) retirer une partie de ladite couche conductrice du dessus de la plaque ;
d) graver ladite plaque jusqu'à sa couche conductrice du dessous selon la forme de ladite partie retirée de la couche conductrice du dessus afin de former au moins une cavité dudit moule.

Conformément à d'autres caractéristiques avantageuses de l'invention :
- le procédé comporte, à la suite de l'étape d), l'étape e) : monter une pièce sur la couche conductrice du dessus de ladite plaque afin de former un deuxième niveau dudit moule;
- l'étape e) est obtenue en structurant une résine photosensible par photolithographie ou en solidarisant une pièce en matériau à base de silicium préalablement gravé ;
- le procédé comporte, à la suite de l'étape d), l'étape f) : former une tige par photolithographie dans ladite au moins une cavité afin de former un trou d'axe dans ladite pièce ;
- la couche adhésive et la couche conductrice du dessous sont inversées ;
- la couche adhésive comporte une résine photosensible ;
- le substrat comporte un matériau à base de silicium ;
- le procédé comporte l'étape d') : graver le substrat jusqu'à la couche conductrice du dessus afin de former au moins un creux du moule.
- le procédé comporte, à la suite de l'étape d'), l'étape e') : monter une pièce sur une couche conductrice déposée sur le dessus du substrat afin de former un niveau supplémentaire du moule ;
- le procédé comporte, à la suite de l'étape d'), l'étape f') : former une tige par photolithographie dans ledit au moins un creux afin de former un trou d'axe dans la pièce ;
- l'étape d) comporte les phases g) : structurer un masque de protection par photolithographie à l'aide d'une résine photosensible sur la portion de la couche conductrice du dessus non retirée, h) : réaliser une attaque anisotropique de la plaque selon les parties non recouvertes par ledit masque de protection et i) : retirer le masque de protection ;
- l'étape d) comporte la phase h') : réaliser une attaque anisotropique de la plaque en utilisant la couche conductrice du dessus comme masque afin de graver la plaque selon les parties retirées de ladite couche conductrice ;
- plusieurs moules sont fabriqués sur le même substrat.

L'invention se rapporte également à un procédé de fabrication par galvanoplastie d'une pièce de micromécanique, **caractérisé en ce qu**'il comprend les étapes suivantes :
j) fabriquer un moule selon le procédé conforme à l'une des variantes précédentes ;
k) réaliser une électrodéposition en connectant l'électrode à la couche conductrice du dessous de la plaque en matériau à base de silicium afin de former ladite pièce dans ledit moule ;
l) libérer la pièce dudit moule.

Enfin, l'invention se rapporte avantageusement à un moule destiné à fabriquer une pièce de micromécanique par galvanoplastie, caractérisé en **ce qu**'il comporte un substrat, une pièce en matériau à base de silicium montée sur ledit substrat et comportant au moins une cavité découvrant une surface électriquement conductrice dudit substrat permettant de faire croître un dépôt électrolytique dans ladite au moins une cavité

Conformément à d'autres caractéristiques avantageuses de l'invention :
- le moule comporte une deuxième pièce montée sur la première et comportant au moins un évidement découvrant une surface électriquement conductrice et au moins une cavité de ladite première pièce permettant de continuer le dépôt électrolytique dans ledit au moins un évidement après avoir rempli ladite au moins une cavité ;
- le substrat est formé d'un matériau à base de silicium et comporte au moins un creux découvrant une surface électriquement conductrice dudit substrat permettant de faire croître un dépôt électrolytique dans ledit au moins un creux ;
- le moule comporte une pièce supplémentaire montée sur le substrat et comportant au moins un évidement découvrant une surface électriquement conductrice et au moins un creux dudit substrat permettant de continuer le dépôt électrolytique dans ledit au moins un évidement après avoir rempli ledit au moins un creux.

### Description sommaire des dessins

D'autres particularités et avantages ressortiront clairement de la description qui en est faite ci-après, à titre indicatif et nullement limitatif, en référence aux dessins annexés, dans lesquels
- les figures 1 à 7 sont des représentations des étapes successives d'un procédé de fabrication d'une pièce de micromécanique selon l'invention ;
- la figure 8 est un schéma fonctionnel d'un procédé de fabrication d'une pièce de micromécanique selon l'invention ;
- les figures 9 à 13 sont des représentations des étapes finales successives d'un procédé de fabrication d'une pièce de micromécanique selon l'invention.

### Description détaillée des modes de réalisation préférés

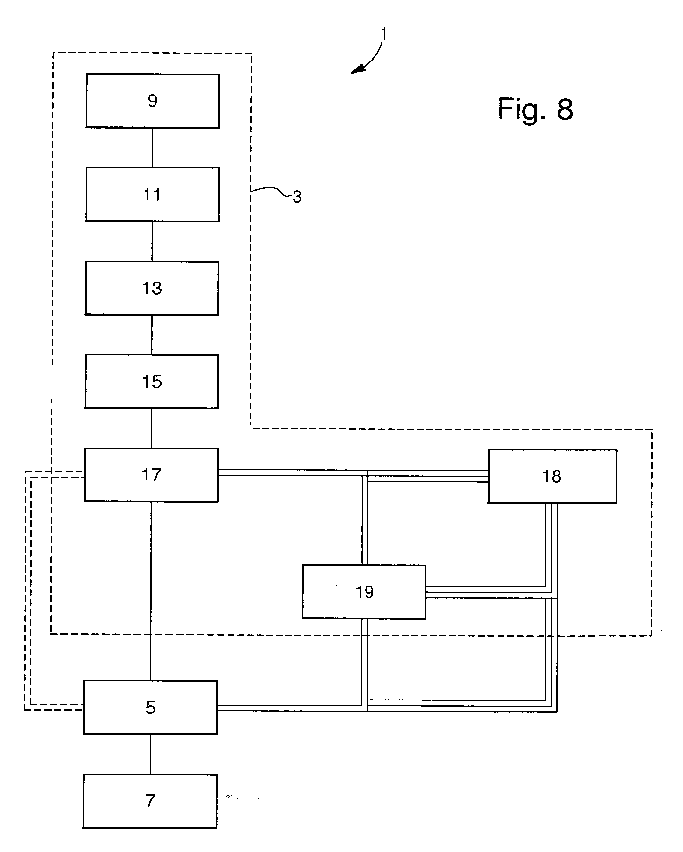

Comme visible à la figure 8, l'invention se rapporte à un procédé de fabrication 1 d'une pièce de micromécanique 41, 41' par galvanoplastie. Le procédé 1 comporte, préférentiellement, un procédé de fabrication 3 d'un moule 39, 39' suivi d'étapes de galvanoplastie 5 et de libération 7 de la pièce 41, 41' dudit moule.

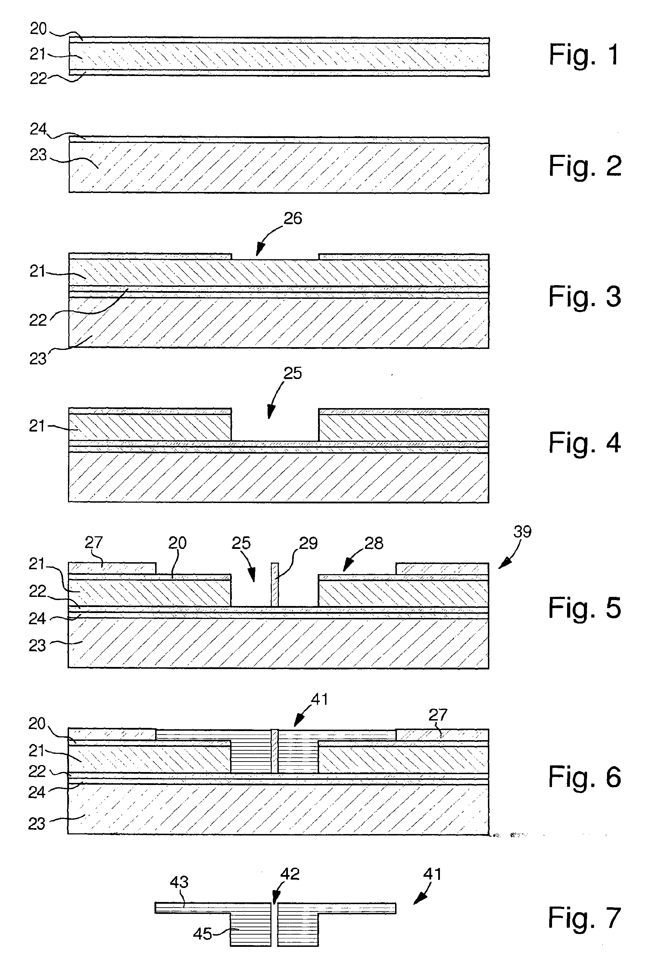

Le procédé de fabrication 3 du moule comporte des étapes successives destinées à fabriquer un moule 39, 39' comportant au moins une pièce 21 en matériau à base de silicium. Dans une première étape 9 du procédé 3, une plaque 21 en matériau à base de silicium est revêtue sur son dessus et son dessous de couches électriquement conductrices respectivement annotées 20 et 22 comme illustré à la figure 1. Les couches conductrices 20, 22 peuvent comporter, par exemple, de l'or ou du cuivre.

Dans une deuxième étape 11, un substrat 23, qui peut être également à base de silicium, est revêtu sur son dessus d'une couche 24 de matériau adhésif comme illustré à la figure 2. Un tel matériau peut, par exemple, être une résine photosensible non activée ou plus généralement une résine adhésive facilement retirable. La couche adhésive 24 est destinée, lors de la troisième étape 13, à solidariser au moins temporairement la plaque 21 revêtue avec le substrat 23 comme illustré à la figure 3.

Selon une alternative de l'invention, la couche adhésive 24 et la couche conductrice 22 du dessous sont inversées comme expliqué ci-dessous.

Dans une quatrième étape 15, une partie 26 de la couche conductrice 20 du dessus de la plaque 21 est retirée afin de découvrir partiellement le dessus de la plaque 21 comme illustré à la figure 3. Dans une cinquième étape 17, la plaque 21 est gravée jusqu'à découvrir sa couche conductrice 22 du dessous. Selon l'invention, l'étape 17 de gravage est préférentiellement réalisée selon le même motif que la partie 26 retirée de la couche conductrice 20 lors de l'étape 15.

L'étape de gravage 17 comporte, de manière préférée, une attaque sèche anisotropique du type gravage ionique réactif profond (DRIE provenant des termes anglais « Deep Reactive Ion Etching »).

Selon une première variante de l'étape 17, le matériau de la couche conductrice 20 du dessus de la plaque 21 est choisi afin de servir de masque de protection. Ainsi, quand l'ensemble masque 20 - plaque 21 est soumis à l'attaque anisotropique, seules les parties 26 de la plaque non protégées sont gravées. A la fin de l'étape 17, on obtient donc au moins une cavité 25 dans la plaque 21 dont le fond laisse apparaître partiellement la couche conductrice 22 du dessous comme illustré à la figure 4.

Selon une deuxième variante de l'étape 17, dans un premier temps, un masque de protection est revêtu sur la plaque 21, préférentiellement, selon les mêmes formes que les parties retirées 26, par exemple, à l'aide d'un procédé de photolithographie d'une résine photosensible. Dans un deuxième temps, quand l'ensemble masque - plaque est soumis à l'attaque anisotropique, seules les parties de la plaque non protégées sont gravées. Finalement, dans un troisième temps, le masque de protection est retiré. A la fin de l'étape 17, on obtient donc au moins une cavité 25 dans la plaque 21 dont le fond laisse apparaître partiellement la couche conductrice 22 du dessous comme illustré à la figure 4.

Dans le cas de l'alternative citée ci-dessus illustrée en trait triple à la figure 8, dans laquelle la couche adhésive 24 et la couche conductrice 22 du dessous sont inversées, il est en plus nécessaire, lors d'une étape 18, de continuer ladite cavité 25 dans la couche adhésive 24 afin de découvrir ladite couche conductrice 22 du dessous. Préférentiellement, le matériau utilisé selon cette alternative est alors une résine photosensible que l'on expose à un rayonnement afin d'y continuer la cavité 25.

A la suite de l'étape 17, l'invention prévoit deux modes de réalisation. Dans un premier mode de réalisation illustré en trait simple à la figure 8, à la suite de l'étape 17, le procédé de fabrication 3 du moule est terminé et le procédé de fabrication 1 de la pièce de micromécanique se poursuit immédiatement par les étapes de galvanoplastie 5 et de libération 7 de la pièce dudit moule. L'étape 5 de galvanoplastie est réalisée en connectant l'électrode de dépôt à la couche conductrice 22 du dessous de la plaque 21 afin de faire croître un dépôt électrolytique dans la cavité 25 dudit moule puis, dans l'étape 7, la pièce formée dans la cavité 25 est libérée dudit moule.

Selon ce premier mode de réalisation, on comprend que la pièce de micromécanique obtenue comporte un seul niveau dont la forme est identique sur toute son épaisseur.

Selon le deuxième mode de réalisation illustré en trait double à la figure 8, l'étape 17 est suivie d'une étape 19 destinée à former au moins un deuxième niveau 28 au moule 39. Ainsi, le deuxième niveau 28 est réalisé en montant une pièce 27 sur une partie de la couche conductrice 20 du dessus qui n'a pas été retirée lors de l'étape 15.

Préférentiellement, la pièce 27 est formée sur la couche conductrice 20 selon un évidement 28 de section plus grande que les parties retirées 26, par exemple, à l'aide d'un procédé de photolithographie d'une résine photosensible.

De plus, comme illustré à la figure 5, de manière préférée lors de l'étape 19, une tige 29 est montée afin de former directement le trou 42 d'axe de la pièce 41 de micromécanique lors de la galvanoplastie. Cela présente l'avantage non seulement de ne pas à avoir à usiner la pièce 41 une fois la galvanoplastie terminée mais également de pouvoir réaliser n'importe quelle forme de section intérieure, de manière uniforme ou non, sur toute la hauteur du trou 42. Préférentiellement, la tige 29 est obtenue lors de l'étape 19 en même temps que la pièce 27, par exemple, à l'aide d'un procédé de photolithographie d'une résine photosensible.

Dans le deuxième mode de réalisation, à la suite de l'étape 19, le procédé de fabrication 3 du moule 39 est terminé et le procédé de fabrication 1 de la pièce de micromécanique se poursuit par les étapes de galvanoplastie 5 et de libération 7 de la pièce dudit moule.

L'étape 5 de galvanoplastie est réalisée en connectant l'électrode de dépôt à la couche conductrice 22 du dessous de la plaque 21 afin de faire croître dans un premier temps un dépôt électrolytique dans la cavité 25 dudit moule puis, seulement dans un deuxième temps, dans l'évidement 28 comme illustré à la figure 6.

En effet, avantageusement selon l'invention, lorsque le dépôt électrolytique affleure de la partie supérieure de la cavité 25, il connecte électriquement la couche conductrice 20 ce qui permet la continuation de la croissance du dépôt sur l'ensemble de l'évidement 28. Avantageusement, l'invention permet la réalisation de pièce à grand élancement, c'est-à-dire quand la section de la cavité 25 est beaucoup plus petite que celle de l'évidement 28, en évitant les problèmes de décollement même avec un matériau en nickel - phosphore à, par exemple, 12% de phosphore.

En effet, grâce à l'utilisation du silicium sous la couche conductrice 20, les phénomènes de délamination aux interfaces sont diminués ce qui évite les décollements induits par les contraintes internes du matériau électrodéposé.

Selon le deuxième mode de réalisation, le procédé de fabrication 1 se termine par l'étape 7, dans laquelle la pièce 41 formée dans la cavité 25 puis dans l'évidement 28 est libérée du moule 39. L'étape 7 de libération peut, par exemple, être effectuée par délamination de la couche 24 ou par gravure du substrat 23 et de la plaque 21. Selon ce deuxième mode de réalisation, on comprend comme illustré à la figure 7 que la pièce de micromécanique 41 obtenue comporte deux niveaux 43, 45 de forme différente chacun selon une épaisseur parfaitement indépendante.

Une telle pièce 41 de micromécanique pourrait, par exemple, être une roue d'échappement coaxiale ou un ensemble roue d'échappement 43 - pignon 45 comportant une précision géométrique de l'ordre du micromètre mais également un référencement idéal c'est-à-dire un positionnement parfait entre lesdits niveaux.

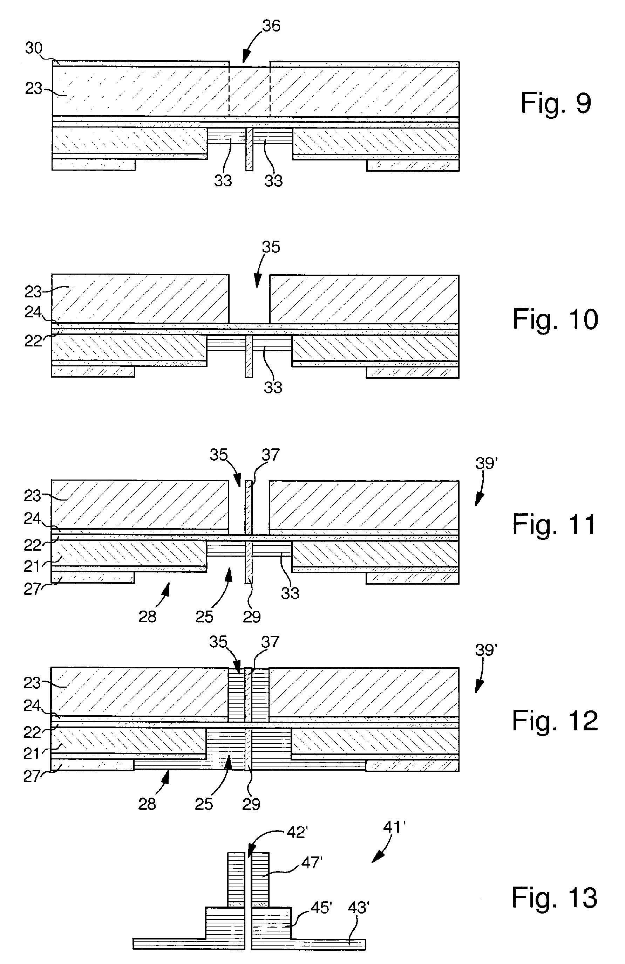

Selon une deuxième variante du procédé 1 illustrée en traits discontinus double aux figures 1 à 5 et 8 à 13, il est possible de rajouter au moins un troisième niveau au moule 39. La deuxième variante reste identique au procédé 1 décrit ci-dessus jusqu'à l'étape 17, 18 ou 19 suivant l'alternative ou le mode de réalisation utilisé. Dans l'exemple illustré aux figures 9 à 13, on prendra prendre comme point de départ, l'exemple du deuxième mode de réalisation comme illustré à la figure 8 en trait double.

Préférentiellement selon cette deuxième variante, le substrat 23 est formé à partir d'un matériau à base de silicium et est destiné à être gravé afin de former un creux 35 du moule 39'.

Comme visible, de manière préférée entre la figure 5 et la figure 9, un dépôt 33 a été réalisé dans une partie de la cavité 25 afin de fournir une couche conductrice, plus épaisse que la couche 22 seule, dans le but de mécaniquement supporter les étapes de la deuxième variante du procédé 1. Préférentiellement, ce dépôt 33 est effectué en commençant l'étape 5 jusqu'à une épaisseur prédéterminée. Cependant, ce dépôt peut être effectué selon un autre procédé.

Comme illustré par des traits double discontinus à la figure 8, la deuxième variante du procédé 1 applique les étapes 17, 18 et/ou 19 de la fin du procédé 3, au substrat 23. Ainsi, à la nouvelle étape 17, le substrat 23 est gravée jusqu'à découvrir la couche conductrice 22. L'étape de gravage 17 comporte, de manière préférée, une attaque sèche anisotropique du type gravage ionique réactif profond (DRIE).

Préférentiellement, dans un premier temps illustré à la figure 9, un masque de protection 30 est revêtu sur le substrat 23 comportant des parties ajourées 36, par exemple, à l'aide d'un procédé de photolithographie d'une résine photosensible. Dans un deuxième temps, l'ensemble masque 30 - substrat 23 est soumis à l'attaque anisotropique, seules les parties du substrat non protégées étant gravées.

Dans un troisième temps, le masque 30 de protection est retiré. On obtient ainsi au moins un creux 35 dans le substrat 23 dont le fond laisse apparaître partiellement la couche adhésive 24 comme illustré à la figure 10. Enfin, dans un quatrième temps, le creux 35 est prolongé dans la couche 24 et, éventuellement, également dans la couche 22. Préférentiellement, le matériau utilisé pour la couche adhésive 24 est une résine photosensible que l'on expose à un rayonnement afin d'y continuer le creux 35. A la fin de l'étape 17, on obtient donc au moins un creux 35 dans le substrat 23 dont le fond laisse apparaître partiellement la couche conductrice 22 ou, éventuellement, le dépôt 33.

Bien entendu, de manière analogue à l'explication ci-dessus, une couche conductrice peut également être déposée sur le substrat 23 à la place du masque 30 en résine photostructurée dont le matériau est choisi afin de servir de masque de protection.

De même, dans le cas de l'alternative citée ci-dessus dans laquelle la couche adhésive 24 et la couche conductrice 22 du dessous sont inversées, il n'est plus nécessaire de continuer ledit creux 35 dans la couche adhésive 24 afin de découvrir la couche conductrice 22 ou, éventuellement, le dépôt 33.

A la suite de l'étape 17 de la deuxième variante, l'invention peut prévoir également les deux modes de réalisation cités ci-dessus, c'est-à-dire poursuivre par les étapes de galvanoplastie 5 et de libération 7 ou poursuivre avec une étape 19 destinée à former au moins un niveau supplémentaire sur le substrat 23. Pour simplifier les figures, les figures 11 à 13 sont réalisées à partir du premier mode de réalisation.

De manière préférée, quel que soit le mode de réalisation choisi, comme illustré à la figure 11, une tige 37 est montée afin de former directement le trou 42' d'axe de la pièce 41' de micromécanique lors de la galvanoplastie. Préférentiellement, si les tiges 29 et 37 sont formées respectivement dans la cavité 25 et le creux 35, elles sont alignées. Préférentiellement, la tige 37 est obtenue, par exemple, à l'aide d'un procédé de photolithographie d'une résine photosensible.

A la suite des nouvelles étapes 17 ou 19, l'étape 5 de galvanoplastie est réalisée en connectant l'électrode de dépôt à la couche conductrice 22 afin de faire croître un dépôt électrolytique dans le creux 35 mais également continuer la croissance du dépôt 33 dans la cavité 25, puis, seulement dans un deuxième temps, dans l'évidement 28 comme illustré à la figure 12. Le procédé de fabrication 1 se termine par l'étape 7, dans laquelle la pièce 41' est libérée du moule 39' comme expliqué ci-dessus.

Selon cette deuxième variante, on comprend comme illustré à la figure 13 que la pièce de micromécanique 41' obtenue comporte au moins trois niveaux 43', 45' et 47' de forme différente chacun selon une épaisseur parfaitement indépendante avec un trou d'axe unique 42'.

Une telle pièce 41' de micromécanique pourrait, par exemple, être une roue d'échappement coaxiale 43', 45' avec son pignon 47' ou un mobile à trois niveaux de dentures 43', 45', 47' comportant une précision géométrique de l'ordre du micromètre mais également un référencement idéal c'est-à-dire un positionnement parfait entre lesdits niveaux.

Bien entendu, la présente invention ne se limite pas à l'exemple illustré mais est susceptible de diverses variantes et modifications qui apparaîtront à l'homme de l'art. En particulier, la pièce 27 pourrait comporter un matériau à base de silicium préalablement gravé puis être solidarisée sur la couche conductrice 20.

En outre, plusieurs moules 39, 39' sont fabriqués à partir du même substrat 23 afin de réaliser une production en série de pièces de micromécanique 41, 41' qui ne sont pas forcément identiques entre elles.

De même, une tige 29 peut être formée dans la cavité 25 afin de former un trou d'axe 42 à la future pièce 41 même dans le cadre du premier mode de réalisation à un seul niveau. On peut également envisager changer les matériaux à base de silicium par de l'alumine cristallisée, du carbure de silicium ou de la silice cristallisée.

Enfin, la couche 20 formée lors de l'étape 9 puis partiellement ajourée à l'étape 15 peut également être obtenu par une étape unique 15 de dépôt sélectif. Une telle étape 15 pourrait alors consister, dans un premier temps, à déposer, préalablement au dépôt de la couche conductrice 20, une couche sacrificielle selon la même forme que la section 26. Dans un deuxième temps, une couche conductrice 20 est déposée pardessus l'ensemble. Enfin, dans un troisième temps, la couche sacrificielle est retirée et, incidemment, la partie de couche conductrice déposée dessus ce qui permet d'obtenir la même couche 20 que celle visible à la figure 3. Une telle étape 15 est également connu sous les termes anglais « lift-off ».

## Revendications

1. Procédé de fabrication (3) d'un moule (39, 39') comportant les étapes suivantes :
a) déposer (9) une couche électriquement conductrice sur le dessus (20) et sur le dessous (22) d'une plaque (21) en matériau à base de silicium ;
b) solidariser (13) ladite plaque à un substrat (23) à l'aide d'une couche adhésive ;
c) retirer (15) une partie (26) de ladite couche conductrice du dessus de la plaque (21) ;
d) graver (17) ladite plaque jusqu'à sa couche conductrice (22) du dessous selon la forme (26) de ladite partie retirée de la couche conductrice (22) du dessus afin de former au moins une cavité (25) dudit moule.

2. Procédé (3) selon la revendication 1, **caractérisé en ce qu'**il comporte, à la suite de l'étape d), l'étape suivante :
e) monter (19) une pièce (27) sur la couche conductrice (20) du dessus de ladite plaque afin de former un deuxième niveau (28) dudit moule.

3. Procédé (3) selon la revendication 2, **caractérisé en ce que** l'étape e) est obtenue en structurant une résine photosensible par photolithographie.

4. Procédé (3) selon la revendication 2, **caractérisé en ce que** l'étape e) est obtenue en solidarisant une pièce (27) en matériau à base de silicium préalablement gravé.

5. Procédé (3) selon l'une des revendications précédentes, **caractérisé en ce qu'**il comporte, à la suite de l'étape d), l'étape suivante :
f) former une tige (29) par photolithographie dans ladite au moins une cavité (25) afin de former un trou (42) d'axe dans ladite pièce.

6. Procédé (3) selon l'une des revendications précédentes, **caractérisé en ce que** la couche adhésive (24) et la couche conductrice (22) du dessous sont inversées.

7. Procédé (3) selon l'une des revendications précédentes, **caractérisé en ce que** la couche adhésive (24) comporte une résine photosensible.

8. Procédé selon l'une des revendications précédentes, **caractérisé en ce que** le substrat (23) comporte un matériau à base de silicium.

9. Procédé (3) selon l'une des revendications 8, **caractérisé en ce qu'**il comporte l'étape suivante :
d') graver (17) le substrat (23) jusqu'à la couche conductrice (22) du dessous afin de former au moins un creux (35) du moule (39').

10. Procédé (3) selon la revendication 9, **caractérisé en ce qu'**il comporte, à la suite de l'étape d'), l'étape suivante :
e') monter une pièce sur une couche conductrice déposée sur le dessous du substrat (23) afin de former un niveau supplémentaire du moule (39').

11. Procédé (3) selon la revendication 9 ou 10, **caractérisé en ce qu'**il comporte, à la suite de l'étape d'), l'étape suivante :
f') former une tige (37) par photolithographie dans ledit au moins un creux (35) afin de former un trou (42') d'axe dans la pièce (41').

12. Procédé (3) selon l'une des revendications précédentes, **caractérisé en ce que** l'étape d) comporte les phases suivantes :
g) structurer un masque de protection par photolithographie à l'aide d'une résine photosensible sur la portion de la couche conductrice du dessus non retirée ;
h) réaliser une attaque anisotropique de la plaque selon les parties non recouvertes par ledit masque de protection ;
i) retirer le masque de protection.

13. Procédé (3) selon l'une des revendications 1 à 11, **caractérisé en ce que** l'étape d) comporte la phase suivante :
h') réaliser une attaque anisotropique de la plaque en utilisant la couche conductrice du dessus comme masque afin de graver la plaque selon les parties retirées de ladite couche conductrice ;

14. Procédé (3) selon l'une des revendications précédentes, **caractérisé en ce que** plusieurs moules (39, 39') sont fabriqués à partir du même substrat (23).

15. Procédé de fabrication (1) par galvanoplastie d'une pièce de micromécanique (41, 41'), **caractérisé en ce qu'**il comprend les étapes suivantes :
j) fabriquer un moule (39, 39') selon le procédé (3) conforme à l'une des revendications précédentes ;
k) réaliser (5) une électrodéposition en connectant l'électrode à la couche conductrice (22) du dessous de la plaque (21) en matériau à base de silicium afin de former ladite pièce dans ledit moule ;
l) libérer (7) la pièce (41, 41') dudit moule.

16. Moule (39, 39') destiné à fabriquer une pièce de micromécanique (41, 41') par galvanoplastie, **caractérisé en ce qu'**il comporte un substrat (23), une pièce (21) en matériau à base de silicium montée sur ledit substrat et comportant au moins une cavité (25) découvrant une surface (22) électriquement conductrice dudit substrat permettant de faire croître un dépôt électrolytique dans ladite au moins une cavité.

17. Moule (39, 39') selon la revendication 16, **caractérisé en ce qu'**il comporte une deuxième pièce (27) montée sur la première (21) et comportant au moins un évidement (28) découvrant une surface (20) électriquement conductrice et au moins une cavité (25) de ladite première pièce permettant de continuer le dépôt électrolytique dans ledit au moins un évidement après avoir rempli ladite au moins une cavité.

18. Moule (39') selon l'une des revendications 16 ou 17, **caractérisé en ce que** le substrat (23) est formé d'un matériau à base de silicium et comporte au moins un creux (35) découvrant une surface (22) électriquement conductrice dudit substrat permettant de faire croître un dépôt électrolytique dans ledit au moins un creux.

19. Moule (39') selon la revendication 18, **caractérisé en ce qu'**il comporte une pièce supplémentaire montée sur le substrat (23) et comportant au moins un évidement découvrant une surface électriquement conductrice et au moins un creux (35) dudit substrat permettant de continuer le dépôt électrolytique dans ledit au moins un évidement après avoir rempli ledit au moins un creux.

## Patentansprüche

1. Verfahren für die Herstellung (3) einer Gießform (39, 39'), das die folgenden Schritte umfasst:
a) Ablagern (9) einer elektrisch leitenden Schicht auf der Oberseite (20) und auf der Unterseite (22) einer Platte (21) aus einem Material auf Siliciumbasis;
b) Befestigen (13) der Platte an einem Substrat (23) mit Hilfe einer Klebstoffschicht;
c) Entfernen (15) eines Teils (26) der leitenden Schicht von der Oberseite der Platte (21);
d) Ätzen (17) der Platte bis zu der leitenden Schicht (22 der Unterseite entsprechend der Form (26) des von der Oberseite entfernten Teils der leitenden Schicht (22), um wenigstens einen Hohlraum (25) der Gießform zu bilden.

2. Verfahren (3) nach Anspruch 1, **dadurch gekennzeichnet, dass** es nach dem Schritt d) den folgenden Schritt umfasst:
e) Montieren (19) eines Teils (27) auf der leitenden Schicht (20) der Oberseite der Platte, um eine zweite Ebene (28) der Gießform zu bilden.

3. Verfahren (3) nach Anspruch 2, **dadurch gekennzeichnet, dass** der Schritt e) dadurch erhalten wird, dass ein lichtempfindliches Harz durch Photolithographie strukturiert wird.

4. Verfahren (3) nach Anspruch 2, **dadurch gekennzeichnet, dass** der Schritt e) dadurch erhalten wird, dass ein vorher geätztes Teil (27) aus einem Material auf Siliciumbasis befestigt wird.

5. Verfahren (3) nach einem der vorhergehenden Ansprüche, **dadurch gekennzeichnet, dass** es nach dem Schritt d) den folgenden Schritt umfasst:
f) Bilden eines Stifts (29) durch Photolithographie in dem wenigstens einen Hohlraum (25), um in dem Teil ein Wellenloch (42) zu bilden.

6. Verfahren (3) nach einem der vorhergehenden Ansprüche, **dadurch gekennzeichnet, dass** die Klebstoffschicht (24) und die leitende Schicht (22) der Unterseite vertauscht sind.

7. Verfahren (3) nach einem der vorhergehenden Ansprüche, **dadurch gekennzeichnet, dass** die Klebstoffschicht (24) ein lichtempfindliches Harz enthält.

8. Verfahren nach einem der vorhergehenden Ansprüche, **dadurch gekennzeichnet, dass** das Substrat (23) ein Material auf Siliciumbasis enthält.

9. Verfahren (3) nach Anspruch 8, **dadurch gekennzeichnet, dass** es den folgenden Schritt umfasst:
d') Ätzen (17) des Substrats (23) bis zu der leitenden Schicht (22) der Unterseite, um wenigstens eine Vertiefung (35) der Gießform (39') zu bilden.

10. Verfahren (3) nach Anspruch 9, **dadurch gekennzeichnet, dass** es nach dem Schritt d') den folgenden Schritt umfasst:
e') Montieren eines Teils auf der leitenden Schicht, die auf der Unterseite des Substrats (23) abgelagert ist, um eine zusätzliche Ebene der Gießform (39') zu bilden.

11. Verfahren (3) nach Anspruch 9 oder 10, **dadurch gekennzeichnet, dass** es nach dem Schritt d') den folgenden Schritt umfasst:
f) Bilden eines Stifts (37) durch Photolithographie in dem wenigstens einen Hohlraum (35), um in dem Teil (41') ein Wellenloch (42') zu bilden.

12. Verfahren (3) nach einem der vorhergehenden Ansprüche, **dadurch gekennzeichnet, dass** der Schritt d) die folgenden Phasen umfasst:
g) Strukturieren einer Schutzmaske durch Photolithographie mit Hilfe eines lichtempfindlichen Harzes auf dem nicht entfernten Abschnitt der leitenden Schicht der Oberseite;
h) Ausführen eines anisotropen Angreifens der Platte in den nicht durch die Schutzmaske abgedeckten Teilen;
i) Entfernen der Schutzmaske.

13. Verfahren (3) nach einem der Ansprüche 1 bis 11, **dadurch gekennzeichnet, dass** der Schritt d) die folgende Phase umfasst:
h') Ausführen eines anisotropen Angreifens der Platte unter Verwendung der leitenden Schicht der Oberseite als Maske, um die Platte in den entfernten Teilen der leitenden Schicht zu ätzen.

14. Verfahren (3) nach einem der vorhergehenden Ansprüche, **dadurch gekennzeichnet, dass** mehrere Gießformen (39, 39') anhand desselben Substrats (23) hergestellt werden.

15. Verfahren für die Herstellung (1) durch Galvanoplastik eines mikromechanischen Teils (41, 41'), **dadurch gekennzeichnet, dass** es die folgenden Schritte umfasst:
j) Herstellen einer Gießform (39, 39') gemäß dem Verfahren (3) nach einem der vorhergehenden Ansprüche;
k) Ausführen (5) einer Metallisierung durch Verbinden der Elektrode mit der leitenden Schicht (22) der Unterseite der Platte (21) aus einem Material auf Siliciumbasis, um das Teil in der Gießform zu bilden;
l) Freigeben (7) des Teils (41, 41') von der Gießform.

16. Gießform (39, 39'), die dazu bestimmt ist, ein mikromechanisches Teil (41, 41') durch Galvanoplastik herzustellen, **dadurch gekennzeichnet, dass** sie ein Substrat (23) und ein Teil (21) aus einem Material auf Siliciumbasis umfasst, wobei das Teil auf dem Substrat montiert ist und wenigstens einen Hohlraum (25) aufweist, der eine elektrisch leitende Oberfläche (22) des Substrats abdeckt und ermöglicht, dass in dem wenigstens einen Hohlraum ein Elektrolytniederschlag aufwächst.

17. Gießform (39, 39') nach Anspruch 16, **dadurch gekennzeichnet, dass** sie ein zweites Teil (27) umfasst, das auf dem ersten Teil (21) montiert ist und wenigstens eine Aussparung (28) aufweist, die eine elektrisch leitende Oberfläche (20) und wenigstens einen Hohlraum (25) des ersten Teils abdeckt und ermöglicht, den Elektrolytniederschlag in der wenigstens einen Aussparung fortzusetzen, nachdem der wenigstens eine Hohlraum gefüllt worden ist.

18. Gießform (39') nach einem der Ansprüche 16 oder 17, **dadurch gekennzeichnet, dass** das Substrat (23) aus einem Material auf Siliciumbasis gebildet wird und wenigstens einen Hohlraum (35) aufweist, der eine elektrisch leitende Oberfläche (22) des Substrats abdeckt und ermöglicht, dass in der wenigstens einen Vertiefung ein Elektrolytniederschlag aufwächst.

19. Gießform (39') nach Anspruch 18, **dadurch gekennzeichnet, dass** sie ein zusätzliches Teil umfasst, das auf dem Substrat (23) montiert ist und wenigstens eine Aussparung aufweist, die eine elektrisch leitende Oberfläche und wenigstens einen Hohlraum (35) des Substrats abdeckt und ermöglicht, den Elektrolytniederschlag in der wenigstens einen Aussparung fortzusetzen, nachdem die wenigstens eine Vertiefung gefüllt worden ist.

## Claims

1. Method (3) of fabricating a mould (39, 39') including the following steps:
a) depositing (9) an electrically conductive layer on the top (20) and bottom (22) of a wafer (21) made of silicon-based material;
b) securing (13) said wafer to a substrate (23) using an adhesive layer;
c) removing (15) one part (26) of said conductive layer from the top of the wafer (21);
d) etching (17) said wafer as far as the conductive layer (22) on the bottom thereof in the shape (26) of said part removed from the conductive layer (22) on the top thereof to form at least one cavity (25) in said mould.

2. Method (3) according to claim 1, **characterized in that**, after step d), it includes the following step:
e) mounting (19) a part (27) on the conductive layer (20) on the top of said wafer to form a second level in said mould.

3. Method (3) according to claim 2, **characterized in that** step e) is obtained by structuring a photosensitive resin by photolithography.

4. Method (3) according to claim 2, **characterized in that** step e) is obtained by securing a part (27) made of pre-etched, silicon-based material.

5. Method (3) according to any of the preceding claims, **characterized in that**, after step d), it includes the following step:
f) forming a rod (29) by photolithography in said at least one cavity (25) to form a shaft hole (42) in said part.

6. Method (3) according to any of the preceding claims, **characterized in that**, the adhesive layer (24) and the bottom conductive layer (22) are inverted.

7. Method (3) according to any of the preceding claims, **characterized in that** the adhesive layer (24) includes a photosensitive resin.

8. Method (3) according to any of the preceding claims, **characterized in** the substrate (23) includes a silicon-based material.

9. Method (3) according to claim 8, **characterized in that** it includes the following step:
d') etching (17) the substrate (23) as far as the bottom conductive layer (22) to form at least one hollow (35) in the mould (39').

10. Method (3) according to claim 9, **characterized in that**, after step d'), it includes the following step:
e') mounting a part on a conductive layer deposited on the bottom of the substrate (23) to form an additional level in the mould (39').

11. Method (3) according to claim 9 or 10, **characterized in that**, after step d') it includes the following step:
f) forming a rod (37) by photolithography in said at least one hollow (35) to form a shaft hole (42') in the part (41').

12. Method (3) according to any of the preceding claims, **characterized in that in that** step d) includes the following phases:
g) structuring a protective mask by photolithography using a photosensitive resin on the portion of the top conductive layer that has not been removed;
h) performing an anisotropic etch of the wafer on the parts not coated by said protective mask;
i) removing the protective mask.

13. Method (3) according to any of claims 1 to 11, **characterized in that** step d) includes the following phase:
h') performing an anisotropic etch of the wafer using the top conductive layer as a mask to etch the wafer in the parts removed from said conductive layer.

14. Method (3) according to any of the preceding claims, **characterized in that** several moulds (39, 39') are fabricated from the same substrate (23).

15. Method (1) of fabricating a micromechanical part (41, 41') by galvanoplasty, **characterized in that** it includes the following steps:
j) fabricating a mould (39, 39') according to the method (3) of one of the preceding claims;
k) performing (5) an electrodeposition by connecting the electrode to the conductive layer (22) on the bottom of the wafer (21) made of silicon-based material to form said part in said mould;
I) releasing (7) the part (41, 41') from said mould.

16. Mould (39, 39') for fabricating a micromechanical part (41, 41') by galvanoplasty, **characterized in that** it includes a substrate (23), a part (21) made of silicon-based material, which is mounted on said substrate and includes at least one cavity (25) that reveals an electrically conductive surface (22) of said substrate enabling an electrolytic deposition to be grown in said at least one cavity.

17. Mould (39, 39') according to claim 16, **characterized in that** it includes a second part (27), which is mounted on the first (21) and includes at least one recess (28) that reveals an electrically insulating surface (20) and at least one cavity (25) in said first part, for continuing the electrolytic deposition in said at least one recess after said at least one cavity has been filled.

18. Mould (39') according to claim 16 or 17, **characterized in that** the substrate (23) is formed of a silicon-based material and has at least one hollow (35) that reveals an electrically conductive surface (22) of said substrate, enabling an electrolytic deposition to be grown in said at least one hollow.

19. Mould (39') according to claim 18, **characterized in that** it includes an additional part, which is mounted on the substrate (23) and includes at least one recess revealing an electrically conductive surface and at least one hollow (35) in said substrate, for continuing the electrolytic deposition in said at least one recess after said at least one hollow has been filled.
